# EUROPÄISCHE PATENTSCHRIFT

(11) **EP 1 991 646 B1**
(45) Veröffentlichungstag und Bekanntmachung des Hinweises auf die Patenterteilung: **16.12.2009**
(21) Anmeldenummer: 07710499.0
(22) Anmeldetag: 02.03.2007
(51) Int. Cl.: C10M 141/10, C23C 14/06, F16H 57/04

(54) **BETRIEBSBEREITES GETRIEBE, BETRIEBSFLÜSSIGKEIT FÜR EIN SOLCHES UND VERFAHREN ZU DESSEN ERSTINBETRIEBNAHME**
OPERABLE TRANSMISSION, WORKING FLUID FOR SUCH A TRANSMISSION, AND METHOD FOR COMMISSIONING THE SAME
ENGRENAGE OPÉRATIONNEL, FLUIDE DE FONCTIONNEMENT POUR UN TEL ENGRENAGE ET PROCÉDÉ DE PREMIÈRE MISE EN SERVICE DUDIT ENGRENAGE

(30) Priorität: 03.03.2006 AT 1622006
(43) Veröffentlichungstag der Anmeldung: 19.11.2008
(73) Patentinhaber: Magna Steyr Fahrzeugtechnik AG & Co. KG, 8041 Graz (AT)
(72) Erfinder: MAYR, Franz, A-8323 S.t Marein (AT)
(74) Vertreter: Harringer, Thomas
(86) Internationale Anmeldenummer: PCT/AT2007/000108
(87) Internationale Veröffentlichungsnummer: WO 2007/098523

(56) Entgegenhaltungen:
- EP-A- 1 076 087
- EP-A- 1 503 113
- EP-A- 1 574 757

## Beschreibung

Die Erfindung betrifft ein betriebsbereites Getriebe mit hoch belasteten Zahnrädern, dessen Gehäuse einen ein Schmier- und Kühlmittel enthaltenden Sumpf bildet, in den zumindest ein Zahnrad eintaucht entsprechend dem Oberbegriff des Anspruchs 1 und wie es aus der EP1574757A bekannt ist. Derartige Getriebe kommen in den verschiedensten Anwendungen vor, insbesondere in Kraftfahrzeugen als Schaltgetriebe, Verteilergetriebe von Allradfahrzeugen und als Achs- beziehungsweise Differentialgetriebe.

Bei hochbelasteten Zahnrädern wird auch bei bester Schmierung Verlustwärme erzeugt, die abzuführen ist. Das geschieht entweder durch einen Kühl- und Schmierkreislauf mit Pumpe und einem externen Kühler, oder durch Wärmeableitung an die Umgebung über das Gehäuse des Getriebes. Dazu soll dieses eine möglichst große Oberfläche haben. Bei Kraftfahrzeugen ist es meist aussen verrippt, um die Oberfläche des Wärmeüberganges an den vorbei streichenden Fahrtwind zu vergrößern. Wenn die Motorleistung gesteigert werden soll, ohne dass für das Getriebe mehr Bauraum zur Verfügung steht, wird schnell eine Grenze erreicht.

Zur Zeit werden auch in Getrieben ausschließlich Schmieröle verwendet, in hochbelasteten sind es meist vollsynthetische Öle. Allen Ölen sind jedoch folgende Nachteile gemein:
- Relativ geringe Wärmekapazität, Wärmeleitfähigkeit und niederer Wärmeübergangskoeffizient, (zum Vergleich: ungefähr halb so groß wie die von Wasser)
- Die Viskosität ist stark temperaturabhängig, dadurch erhöhte Verluste in kaltem Zustand und folglich höherer Treibstoffverbrauch,
- Nicht umweltverträglich (Entsorgung !) und auf die Dauer nicht alterungsbeständig.

Deshalb wird schon lange über Alternativen nachgedacht und wurden dazu Versuche angestellt, ohne dass sich solche Alternativen in der Praxis bewährt hätten. Dabei bot sich Wasser wegen seiner hervorragenden thermischen Eigenschaften an. Seine Viskosität ist weitgehend konstant - was einerseits ein Vorteil ist - aber andererseits für die Bildung eines tragfähigen Schmierfilmes zwischen den Zahnflanken nicht ausreicht. Dem versuchte man, durch geeignete Beschichtung der Zahnräder abzuhelfen. Welche Beschichtung man auch immer versuchte, sie war bisher entweder dem Flankendruck oder der Gleitgeschwindigkeit nicht gewachsen, oder sie war überhaupt schon nach kurzer Betriebsdauer verschwunden. Letzteres hat sich auch bei Kohlenstoff - Beschichtungen gezeigt.

Die Suche nach Alternativen findet auch in der Patentliteratur ihren Niederschlag. So ist es etwa aus der US 4,714,414 bekannt, die Zahnräder der Übersetzungsstufe eines Kompressors für ölfreie Druckluft durch versprühtes Wasser zu schmieren. Dass dabei die Zahnräder aus Kunststoff bestehen können, deutet auf geringe zu übertragende Leistung. Es handelt sich somit nicht um hoch belastete Zahnräder.

In dem DE Patent 196 05 162 C1 ist eine synthetische Funktionsflüssigkeit beschrieben, die im wesentlichen nur aus einem Alkylenglykol besteht, dem Korrosions- und Oxydationsinhibitoren zugesetzt sind. Die thermischen Eigenschaften eines Alkylenglykols sind zwar besser als die von Öl, reichen aber an die von Wasser nicht heran. Vor allem ist dessen Viskosität höher, und auch wieder temperaturabhängig.

Es ist somit Aufgabe der Erfindung, ein betriebsbereites Getriebe zu schaffen, das die Nachteile von Schmieröl vermeidet und die Vorteile von Wasser in möglichst hohem Maße nutzt, ohne dessen Nachteile.

Erfindungsgemäß ist als Schmier- und Kühlmittel eine Mischung aus Wasser und einem aliphatischen Kohlenwasserstoff mit mindestens zwei Hydroxilgruppen beziehungsweise mit einer solche Kohlenwasserstoffe enthaltenden Verbindung, in der Graphitteilchen mit einer Korngröße unter 50 Mikrometer suspendiert sind. Aliphatische Kohlenwasserstoffe mit mindestens zwei Hydroxilgruppen sind höherwertige Alkohole, beispielsweise Alkylenglykole, insbesondere Äthylenglykol, Propylenglykol, Triäthylenglykol, etc. Solche Alkohole enthaltende Verbindungen können beispielsweise deren Polymerisate, Oxyde, Äther oder Ester sein.

Bei dem Schmier- und Kühlmittel handelt es sich im Wesentlichen um eine Glykol - Wasser Mischung von der Art, die in Verbrennungskraftmaschinen mit Wasserkühlung als Kühlmittel verwendet wird, die zusätzlich feine Graphit-Teilchen enthält. Die überraschende Wirkung dieses Gemisches beruht darauf, dass Graphit dieser Teilchengröße sich trotz der Anwesenheit von Wasser mit dem Glykol auf den Zahnrädern zu einer Beschichtung vereinigt, die auch bei höchsten Zahnkräften und Gleitgeschwindigkeiten bestens schmiert und die sich durch die von dem mindestens einen eintauchenden Zahnrad geförderte Menge ständig erneuert und verjüngt.

Diese Wirkung wurde in Dauerversuchen und Tests überprüft und mit einem gleichartigen Getriebe mit serienmäßiger Ölfüllung verglichen. Das ist in den weiter unten beschriebenen Ausführungsbeispielen näher ausgeführt. Vorweggenommen sei, dass in serienmäßigen Getrieben mit der erfindungsgemäßen Betriebsflüssigkeit die lastlosen Verluste um bis zu 50% niederer als in demselben Getriebe mit einer konventionellen Ölfüllung und dessen Temperatur in identischem Fahrbetrieb um mindestens 15 Grad tiefer war. Verschleiss war nicht festzustellen. Die mit dem erfindungsgemäßen Schmier- und Kühlmittel erzielte hohe Wärmeaufnahme und Wärmeableitung erlaubt es auch, das Gehäuse des Getriebes näher an die Zahnräder heranzuführen, wodurch ein Getriebe bei gleicher Leistungsfähigkeit weniger Bauraum in Anspruch nimmt.

Damit ist es gelungen, die thermischen Vorteile von Wasser zu nutzen. Die Anwesenheit von Glykol in dem Fluid bannt nebstbei einen großen Nachteil von Wasser: es kann nun nicht mehr einfrieren. Als zusätzlicher Nutzen ist Glykol biologisch abbaubar und Graphit vollkommen inert und daher auch nicht umweltschädlich. Zu betonen ist, dass konstruktive Änderungen an konventionellen Getrieben nur in Sonderfällen erforderlich sind. Es ist nur sicherzustellen, dass der Kunststoff der Dichtringe nicht angegriffen wird und der Schmierkreislauf auch mit dem niedrigviskosen Medium funktioniert.

Die optimalen Mischungsverhältnisse der Komponenten hängen in hohem Maße von der Bauweise des Getriebes und der Art der Zahnräder ab, und auch von den Betriebsbedingungen. Vorzugsweise enthält das Schmier- und Kühlmittel 25 bis 75 Gewichtsprozent des aliphatischen Kohlenwasserstoffes beziehungsweise der solche Kohlenwasserstoffe enthaltenden Verbindung und 1 bis 30 Gewichtsprozent Graphit in Form flockiger Graphitteilchen mit einer Korngröße unter 20 Mikrometer, Rest Wasser und weitere Beimengungen und/oder Zusätze (Anspruch 2). Bei den höheren Werten für den Graphit ist an Zahnräder mit Hypoidverzahnung gedacht.

Für Getriebe enthält das Schmier- und Kühlmittel vorzugsweise 40 bis 60 Gewichtsprozent des aliphatischen Kohlenwasserstoffes beziehungsweise der solche Kohlenwasserstoffe enthaltenden Verbindung und 2 bis 20 Gewichtsprozent Graphit in Form flockiger Graphitteilchen mit einer Korngröße unter 12 Mikrometer, Rest Wasser und weitere Beimengungen und/oder Zusätze (Anspruch 3).

In Weiterbildung der Erfindung enthält das Schmier- und Kühlmittel als weiteren Zusatz ein Dispergieradditiv (Anspruch 4). Dieses sorgt für eine dauerhafte Beschichtung nicht nur der unmittelbar zu schmierenden Teile (Zahnräder, Lager), sondern aller Bauteile und auch der Gehäusewände, welche so vor Korrosion geschützt sind. Das Dispergieradditiv sichert auch nach langem Stillstand einen Anlauf der Zahnräder ohne Trockenreibung. Dispergieradditive sind in der Regel hochmolekulare Block - Copolymere. Vorzugsweise ist die Konzentration des Dispergieradditives im Schmier- und Kühlmittel in Gewichtsprozent die Hälfte bis ungefähr gleich der der Kohlenstoffteilchen (Anspruch 5).

Gemische von Graphit, Wasser und Glykol neigen bisweilen zum Schäumen, was bei kleinen Gehäusen störend ist. Deshalb kann dem Schmier- und Kühlmittel als weiterer Zusatz ein Entschäumer (Anspruch 6) und/oder als weiterer Zusatz auch ein Korrosionsinhibitor (Anspruch 7) zugesetzt sein.

Die Erfindung betrifft auch eine Betriebsflüssigkeit für ein Getriebe mit hoch belasteten Zahnrädern, dessen Gehäuse einen ein Schmier- und Kühlmittel enthaltenden Sumpf bildet, in den die Zahnräder eintauchen, welches Schmier- und Kühlmittel eine Mischung nach einem der Ansprüche 8 bis 14 ist.

Schließlich betrifft die Erfindung auch ein Verfahren zur Erstinbetriebnahme eines Getriebes, etwa bevor dieses in eine Maschine oder in ein Kraftfahrzeug eingebaut wird. Mit diesem wird das Ziel verfolgt, die Vorteile der erfindungsgemäßen Betriebsflüssigkeit möglichst sofort und ohne Einlaufverluste und erhöhten Verschleiß zur Wirkung zu bringen.

Das Verfahren besteht darin, dass das aus der mechanischen Fertigung kommende trockene Getriebe mit dem zuvor ausserhalb des Getriebes vermischten Schmier- und Kühlmittel nach Anspruch 1 zumindest bis zum Betriebs-Pegelstand so weit befüllt wird, dass zumindest eines der Zahnräder in das Schmier- und Kühlmittel eintaucht, dann lastlos durchgedreht wird, bis alle Zahnräder und sonstigen zu schmierenden und schützenden Organe benetzt sind, wobei sich auf den Zahnrädern und überall im Getriebe ein beständiger Schmier- und Schutzfilm bildet (Anspruch 15).

Um den letzteren Effekt weiter zu verstärken, zu beschleunigen und auch in schwer zugänglichen Bereichen zu nutzen, wird in Weiterbildung des Verfahrens als Schritt a) das Getriebe zunächst bis über das Niveau der Achsen mit dem Schmier- und Kühlmittel nach Anspruch 1 befüllt, wobei dieses aber einen höheren Anteil an Graphit (5 bis 30 Gewichtsprozent) enthält, dann eine Weile langsam durchgedreht wird, sodann das Schmier- und Kühlmittel zumindest teilweise abgelassen und das Getriebe schließlich mit einem Schmier- und Kühlmittel nach Anspruch 1 auf den Betriebs - Pegelstand befüllt wird, wobei dieses gegebenenfalls einen entsprechend der Restmenge verminderten Gehalt an Graphitteilchen enthält (Anspruch 16).

Als zusätzlichen Schutz nicht benetzter Stellen, zum Beispiel gegen Reibrost in Steckverzahnungen, kann diese bei der Montage durch Eintauchen oder Bestreichen mit dem Gemisch erreicht werden.

Im folgenden wird die Erfindung anhand von Abbildungen beschrieben und erläutert. Es stellen dar:
- Fig. 1:: Schematisch ein Beispiel eines erfindungsgemäßen Getriebes.
- Fig. 2:: Diagramm mit dem Ergebnis von Vergleichsmessungen an einem beispielsweisen Getriebe.

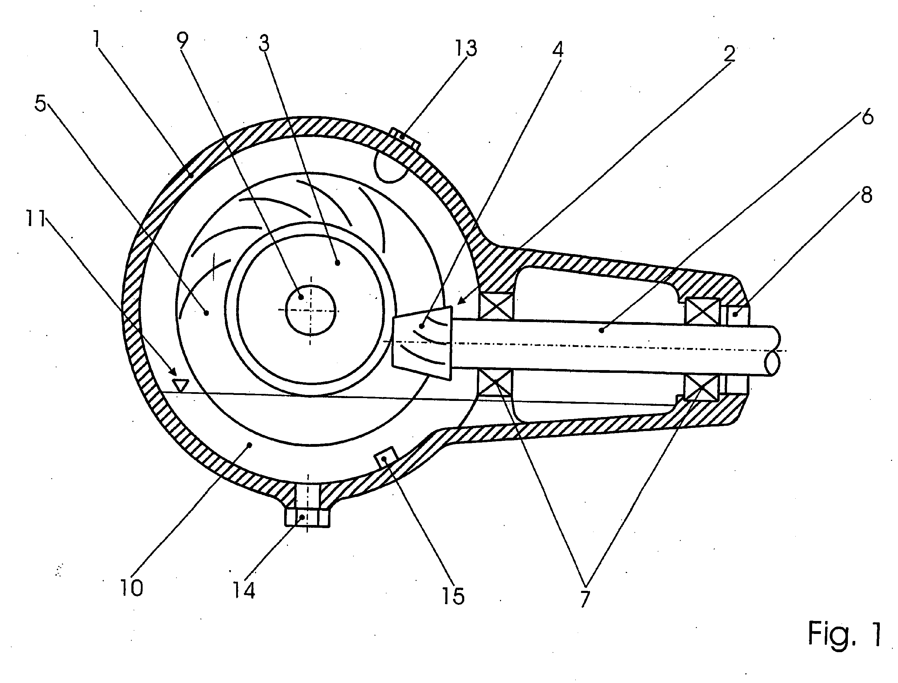

In **Fig. 1** handelt es sich um ein beliebiges serienmäßiges Getriebe, hier um ein Vorderachsgetriebe eines Kraftfahrzeuges mit einem Hypoidtrieb und einem Differential. Es könnte ebenso gut ein Verteilergetriebe oder ein Untersetzungsgetriebe für den Antrieb einer Maschine, beispielsweise in der Lebensmittelindustrie sein. In dem Gehäuse 1 befindet sich der Hypoidtrieb 2 und das Differential 3. Der Hypoidtrieb 2 besteht aus einem auf einer Welle 6 sitzenden Triebling 4 und einem Tellerrad 5. Die Welle 6 ist in Lagern 7 geführt, an deren Äusseres ein Dichtring 8 anschließt. Das Differential 3 ist auch von der üblichen Bauart, und daher nicht aufgeschnitten. Eine zu einem Rad führende Halbwelle 9 ist zu sehen.

Unten im Inneren des Gehäuses ist ein Ölsumpf 10, dessen Flüssigkeitsspiegel bei Stillstand mit 11 bezeichnet ist. Das Tellerrad taucht in den Ölsumpf 10 ein. Weiters ist eine Einfüllöffnung und Entlüftung 13 und ein Ablass 14 für das Schmier- und Kühlmittel sowie ein Temperatursensor (nur für die Versuche eingebaut) angedeutet.

Dieses Getriebe ist jedoch statt mit Getriebeöl mit einem Schmier- und Kühlmittel befüllt, das im wesentlichen aus einem äliphatischen Kohlenwasserstoff mit mindestens zwei Hydroxilgruppen beziehungsweise einer solche Kohlenwasserstoffe enthaltenden Verbindung, darin suspendierten Graphitteilchen mit einer Korngröße unter 50 Mikrometer und Wasser besteht. Als aliphatische Kohlenwasserstoffe mit mindestens zwei Hydroxilgruppen kommen beispielsweise in Frage: Alkylenglykole, insbesondere Äthylenglykol, Propylenglykol, oder Triethylenglykol. Mit verschiedenen solchen Verbindungen, Mischungsverhältnissen und weiteren Zusatzstoffen wurden verschiedene in Versuchen, auch im Fahrversuch mit einem serienmäßig mit Öl befüllten Getriebe, erfolgreich erprobt. Beispielsweise:

### Mischung 1:

| | | |
|---|---|---|
| Glysantin® G48: | 100 Gramm | |
| VE* Wasser: | 100 Gramm | VE*: Vollentsalzt. |
| Graphit FL 1199 | 4 Gramm | FL1199: Graphit-Flocken, das sind Lamellen, mit einer Korngröße von 11 Mikron (µ) und einer Reinheit von 99 % C. |

Im Versuchsprotokoll vermerkt: Geringe Schaumentwicklung, kurzfristig keine Endmischung, geringe Benetzung.

### Mischung 2:

| | | |
|---|---|---|
| Äthylenglykol: | 100 Gramm | |
| VE Wasser: | 100 Gramm | |
| Entschäumer: | 1 Gramm | Entschäumer 150 der Firma Kluthe, Zusammensetzung gemäß Sicherheitsdatenblatt. |
| Dispergieradditiv: | 16 Gramm | Additol® VXW6394 der Firma Cytek, Zusammensetzung gemäß technischem Merkblatt. |
| Korrosionsinhibitor: | 4 Gramm | BWT CW-CS 8 der Firma BWT, Zusammensetzung gemäß Merkblatt von BWT. |
| Graphit FL 1199: | 16 Gramm | Wie in Mischung 1. |

Im Versuchsprotokoll vermerkt: keine Schaumentwicklung, Dispersion stabil, ausgezeichnete und stabile Benetzung, nach Benetzung keine Korrosion nicht dauerhaft benetzter Bereiche, ausgezeichnetes Temperaturverhalten im Verteilergetriebe und Start Dauererprobung, keine ausreichende Schmierung in einem Achsgetriebe mit Hypoidverzahnung.

### Mischung 3:

| | | |
|---|---|---|
| Äthylenglykol: | 100 Gramm | |
| VE Wasser: | 100 Gramm | |
| Entschäumer: | 1 Gramm | Entschäumer 150 der Firma Kluthe, Zusammensetzung gemäß Sicherheitsdatenblatt. |
| Dispergieradditiv: | 20 Gramm | Additol® VXW6394 der Firma Cytek, Zusammensetzung gemäß technischem Merkblatt. |
| Korrosionsinhibitor: | 2 Gramm | BWT CW-CS 8 der Firma BWT, Zusammensetzung gemäß Merkblatt von BWT. |
| Graphit FL 1199: | 40 Gramm | Wie in Mischung 1. |

Im Versuchsprotokoll vermerkt: geringe Schaumentwicklung, Dispersion sehr stabil, ausgezeichnete und stabile Benetzung, nach Benetzung keine Korrosion nicht dauerhaft benetzter Bereiche, gutes Temperatur- und Schmierverhalten im Vorderachsdifferential.

Die Mischung 2 wurde im Fahrversuch mit einer konventionellen und serienmäßigen Ölfüllung im Verteilergetriebe verglichen, wobei ein und dasselbe Getriebe (das Verteilergetriebe eines luxuriösen Allradfahrzeuges, enthaltend eine Stirnradstufe und ein Planetendifferential,) einmal mit der einen und einmal mit der anderen Betriebsflüssigkeit befüllt war.

Es wurden mindestens 150 km mit jeweils konstanter Geschwindigkeit von 100 km/h und 140 km/h auf ebener Autobahn gefahren, um die Beharrungstemperaturen im Getriebe zu ermitteln. Dabei wurde die Temperatur der Betriebsflüssigkeit im Sumpf mit einem Thermo-Messfühler gemessen. Die durchschnittliche Beharrungstemperatur liegt mit der Mischung 2 unabhängig von der Umgebungstemperatur um ca. 13°C niedriger als mit serienmäßiger Ölfüllung. Dies gilt für beide Geschwindigkeitswerte.

Die Mischung 3 wurde im Fahrversuch mit einer konventionellen und serienmäßigen Ölfüllung im Vorderachsgetriebe verglichen, wobei ein und dasselbe Getriebe (das Vorderachsgetriebe eines luxuriösen Allradfahrzeuges, enthaltend eine Hypoid-Kegelradverzahnung und ein Differential,) einmal mit der einen und einmal mit der anderen Betriebsflüssigkeit befüllt war.

Es wurden mindestens 150 km mit jeweils konstanten Geschwindigkeiten von 100 km/h und 140 km/h auf ebener Autobahn gefahren, um die Beharrungstemperatur im Getriebe zu ermitteln. Die durchschnittliche Beharrungstemperatur liegt mit der Mischung 4 unabhängig von der Umgebungstemperatur um 16°C bzw. 13°C niedriger, gültig für 100km/h bzw. 140km/h, als mit serienmäßiger Ölfüllung.

Weiters wurde am Prüfstand ein Vorderachsdifferential mit der Mischung 3 eine halbe Stunde lang mit einer konstanten Eintriebsdrehzahl von 1700 Umdrehungen pro Minute, das entspricht ca. 70 km/h, betrieben und das Temperaturverhalten und das Schleppmoment gemessen.

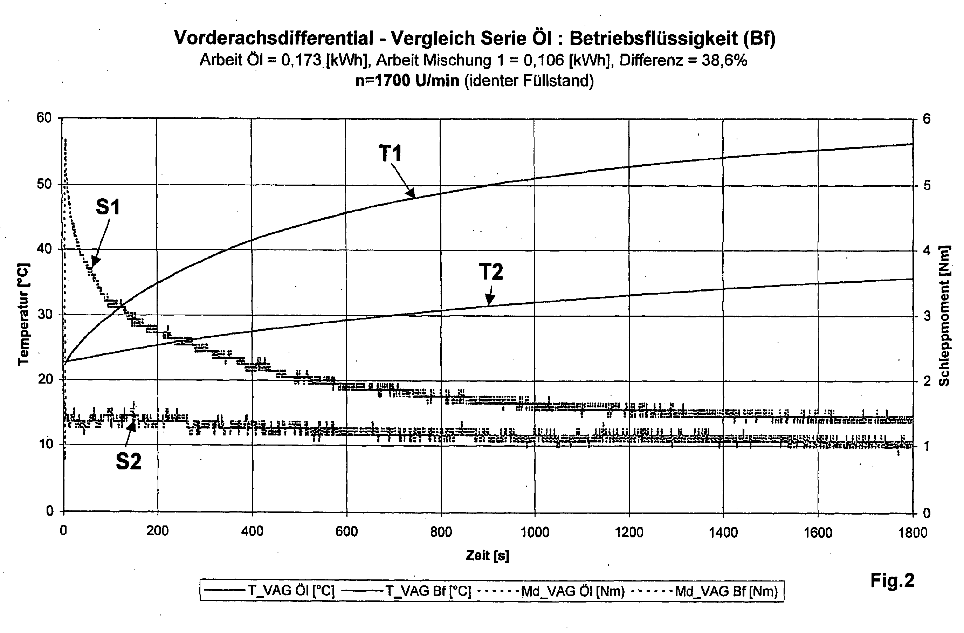

Fig.2 zeigt den Verlauf mit 1700 min⁻¹ der beiden gemessenen Größen Temperatur T der Betriebsflüssigkeit in Grad Celsius und Schleppmonent S in Nm auf der Ordninate, die Zeit auf der Abszisse. Begonnen wird der Versuch mit circa 23°C kaltem Getriebe. Die entsprechenden Kurven sind T1 und S1 für das mit Öl und T2 und S2 für das mit der erfindungsgemäßen Betriebsflüssigkeit befüllte Getriebe. Es ist zu erkennen, dass während der Betriebszeit die Temperatur T1 wesentlich steiler ansteigt und 57 °C erreicht, die Temperatur T2 hingegen langsam bis etwas über 36 °C ansteigt. Das Schleppmoment ist die Summe aller lastlosen Verluste im Getriebe (hauptsächlich Reibungs- und Planschverluste). Das Schleppmoment S 1 im Getriebe mit der Ölfüllung ist wegen der stark temperaturabhängigen Viskosität von Öl anfangs sehr hoch (über 5,5 Nm) und sinkt im Laufe des Betriebes auf ungefähr 1,4 Nm ab. Das Schleppmoment S2 ist vom ersten Moment an annähernd konstant zwischen 1,3 und 1,0 Nm. Daraus ergibt sich als Verlustarbeit in dem Zeitraum von 1800 Sekunden 0,173 kWh für das Öl und 0,106 kWh für die erfindungsgemäße Betriebsflüssigkeit, somit eine Reduzierung der lastlosen Verluste von 38,6 %. Bei winterlichem Kaltstart (bei -30 °C) wurde eine Verringerung der Verlustleistung um über 50% ermittelt.

Aus den Bemerkungen in den Versuchsprotokollen ist zu erkennen, wie wichtig die Benetzung aller Teile des Getriebes ist. Außerdem wurde bei der Vorbereitung der Versuche beobachtet, dass eine rührende Bewegung während einer gewissen Zeit die innige Aufnahme der Graphitlamellen in das Flüssigkeitsgemisch verbessert (homogene Suspension). Daraus wurde ein diesen Faktoren Rechnung tragendes Verfahren zur Erstinbetriebnahme eines mit der erfindungsgemäßen Betriebsflüssigkeit zu befüllenden Getriebes entwickelt:

Das vorher mit konventionellem Schmiermittel befüllte Getriebe wurde entleert und gründlich gereinigt, sodass es einem aus der mechanischen Fertigung kommenden neuen Getriebe gleich kam. Beziehungsweise wurde in der Serienfertigung ein trockenes Getriebe ohne Bandende-Prüfung hergestellt. Das trockene Getriebe wurde mit einer zuvor in einem Behälter vermischten Betriebsflüssigkeit der Mischung 2 bzw. 3 so weit befüllt, dass eines der Zahnräder in das Schmier- und Kühlmittel eintauchte. Dann wurde das Getriebe auf eine entsprechende Vorrichtung aufgespannt und lastlos durchgedreht, bis das von dem einen Zahnrad geförderte und umher geschleuderte alle Zahnräder und sonstige inneren Flächen und Teile mit dem Schmier- und Kühlmittel benetzt hatte. Nach 5 Minuten hatte sich auf den Zahnflanken ein beständiger Schmierfilm gebildet.

In einer Variante wurde das trockene Getriebe zunächst bei Schritt a) bis über das Niveau zumindest einer der Achsen mit einer Betriebflüssigkeit befüllt, die mindestens 10 Gewichtsprozent Graphit enthielt. Nach dem Durchdrehen gemäß Schritt b) wurde die Betriebsflüssigkeit komplett abgelassen und dann das Getriebe mit einer Betriebsflüssigkeit auf den Betriebs - Pegelstand 11 befüllt. Alternativ könnte die Flüssigkeit auch nur teilweise abgelassen und mit einer Flüssigkeit ohne oder mit sehr wenig Graphit aufgefüllt werden. Die richtige Mischung stellt sich dann im Betrieb ein.

## Patentansprüche

1. Betriebsbereites Getriebe mit hoch belasteten Zahnrädern, dessen Gehäuse einen ein Schmier- und Kühlmittel enthaltenden Sumpf bildet, in den die Zahnräder eintauchen, **dadurch gekennzeichnet, dass** es als Schmier- und Kühlmittel eine Mischung aus Wasser und einem aliphatischen Kohlenwasserstoff mit mindestens zwei Hydroxilgruppen beziehungsweise einer solche Kohlenwasserstoffe enthaltenden Verbindung enthält, in der Graphitteilchen mit einer Korngröße unter 50 Mikrometer suspendiert sind.

2. Betriebsbereites Getriebe nach Anspruch 1, **dadurch gekennzeichnet, dass** das Schmier- und Kühlmittel 25 bis 75 Gewichtsprozent des aliphatischen Kohlenwasserstoffes beziehungsweise der solche Kohlenwasserstoffe enthaltenden Verbindung und 1 bis 30 Gewichtsprozent Graphit in Form flockiger Graphitteilchen mit einer Korngröße unter 20 Mikrometer enthält, Rest Wasser und weitere Beimengungen und/oder Zusätze.

3. Betriebsbereites Getriebe nach Anspruch 2, **dadurch gekennzeichnet, dass** das Schmier- und Kühlmittel 40 bis 60 Gewichtsprozent des aliphatischen Kohlenwasserstoffes beziehungsweise der solche Kohlenwasserstoffe enthaltenden Verbindung und 2 bis 20 Gewichtsprozent Graphit in Form flockiger Graphitteilchen mit einer Korngröße unter 12 Mikrometer enthält, Rest Wasser und weitere Beimengungen und/oder Zusätze.

4. Betriebsbereites Getriebe nach Anspruch 2, **dadurch gekennzeichnet, dass** das Schmier- und Kühlmittel als weiteren Zusatz ein Dispergieradditiv enthält.

5. Betriebsbereites Getriebe nach Anspruch 4, **dadurch gekennzeichnet, dass** die Konzentration des Dispergieradditives im Schmier- und Kühlmittel in Gewichtsprozent die Hälfte bis ungefähr gleich der der Kohlenstoffteilchen ist.

6. Betriebsbereites Getriebe nach Anspruch 2, **dadurch gekennzeichnet, dass** das Schmier- und Kühlmittel als weiteren Zusatz einen Entschäumer enthält.

7. Betriebsbereites Getriebe nach Anspruch 2, **dadurch gekennzeichnet, dass** das Schmier- und Kühlmittel als noch weiteren Zusatz einen Korrosionsinhibitor enthält.

8. Betriebsflüssigkeit für ein Getriebe mit hoch belasteten Zahnrädern, dessen Gehäuse einen ein Schmier- und Kühlmittel enthaltenden Sumpf bildet, in den die Zahnräder eintauchen, **dadurch gekennzeichnet, dass** es als Schmier- und Kühlmittel eine Mischung aus Wasser und einem aliphatischen Kohlenwasserstoff mit mindestens zwei Hydroxilgruppen beziehungsweise einer einen solchen Kohlenwasserstoff enthaltenden Verbindung enthält, in der Graphitteilchen mit einer Korngröße unter 50 Mikrometer suspendiert sind.

9. Betriebsflüssigkeit nach Anspruch 8, **dadurch gekennzeichnet, dass** das Schmier- und Kühlmittel 25 bis 75 Gewichtsprozent des aliphatischen Kohlenwasserstoffes beziehungsweise der solche Kohlenwasserstoffe enthaltenden Verbindung und 1 bis 30 Gewichtsprozent Graphit in Form flockiger Graphitteilchen mit einer Korngröße unter 20 Mikrometer enthält, Rest Wasser und weitere Beimengungen und/oder Zusätze.

10. Betriebsflüssigkeit nach Anspruch 9, **dadurch gekennzeichnet, dass** das Schmier- und Kühlmittel 40 bis 60 Gewichtsprozent des aliphatischen Kohlenwasserstoffes beziehungsweise der solche Kohlenwasserstoffe enthaltenden Verbindung und 2 bis 25 Gewichtsprozent Graphit in Form flockiger Graphitteilchen mit einer Korngröße unter 12 Mikrometer enthält, Rest Wasser und weitere Beimengungen und/oder Zusätze.

11. Betriebsflüssigkeit nach Anspruch 9, **dadurch gekennzeichnet, dass** das Schmier- und Kühlmittel als weiteren Zusatz ein Dispergieradditiv enthält.

12. Betriebsflüssigkeit nach Anspruch 11, **dadurch gekennzeichnet, dass** die Konzentration des Dispergieradditives im Schmier- und Kühlmittel in Gewichtsprozent die Hälfte bis ungefähr gleich der der Kohlenstoffteilchen ist.

13. Betriebsflüssigkeit nach Anspruch 9, **dadurch gekennzeichnet, dass** das Schmier- und Kühlmittel als weiteren Zusatz einen Entschäumer enthält.

14. Betriebsflüssigkeit nach Anspruch 9, **dadurch gekennzeichnet, dass** das Schmier- und Kühlmittel als noch weiteren Zusatz einen Korrosionsinhibitor enthält.

15. Verfahren zur Erstinbetriebnahme eines Getriebes, ausgehend von dem trockenen Getriebe, in folgenden Schritten:
a) Vermischen von Wasser, einem aliphatischen Kohlenwasserstoff mit mindestens zwei Hydroxilgruppen beziehungsweise einer einen solchen Kohlenwasserstoff enthaltenden Verbindung und den Graphitteilchen in einem Behälter ausserhalb des Getriebes.
b) Füllen des Getriebes mit dem Schmier- und Kühlmittel nach Anspruch 1 zumindest so weit, dass zumindest eines der Zahnräder in das Schmier- und Kühlmittel eintaucht.
c) Lastloses Durchdrehen des Getriebes, bis alle Zahnräder mit dem Schmier- und Kühlmittel benetzt sind, wobei sich auf diesen ein beständiger Schmierfilm bildet.

16. Verfahren zur Erstinbetriebnahme eines Getriebes nach Anspruch 15, **dadurch gekennzeichnet, dass** als Schritt a) das Getriebe bis über das Niveau zumindest einer der Achsen mit dem Schmier- und Kühlmittel nach Anspruch 1 befüllt wird, wobei dieses 5 bis 20 Gewichtsprozent Graphit, enthält, und dass nach Schritt b) das Schmier- und Kühlmittel zumindest teilweise abgelassen und das Getriebe mit einem Schmier- und Kühlmittel nach Anspruch 1 auf den Betriebs - Pegelstand befüllt wird, wobei dieses gegebenenfalls einen entsprechend der Restmenge verminderten Gehalt an Graphitteilchen enthält.

## Claims

1. Operational transmission comprising highly loaded gearwheels, whose housing forms a sump which contains a lubricant and coolant and into which the gearwheels dip, **characterized in that** said transmission contains, as a lubricant and coolant, a mixture of water and an aliphatic hydrocarbon comprising at least two hydroxyl groups or a compound which contains such hydrocarbons and in which graphite particles with a grain size of less than 50 micrometers are suspended.

2. Operational transmission according to Claim 1, **characterized in that** the lubricant and coolant contains 25 to 75 percent by weight of the aliphatic hydrocarbon or of the compound which contains such hydrocarbons and 1 to 30 percent by weight of graphite in the form of flaky graphite particles with a grain size of less than 20 micrometers, residual water and further admixtures and/or additives.

3. Operational transmission according to Claim 2, **characterized in that** the lubricant and coolant contains 40 to 60 percent by weight of the aliphatic hydrocarbon or of the compound which contains such hydrocarbons and 2 to 20 percent by weight of graphite in the form of flaky graphite particles with a grain size of less than 12 micrometers, residual water and further admixtures and/or additives.

4. Operational transmission according to Claim 2, **characterized in that** the lubricant and coolant contains a disperging additive as a further additive.

5. Operational transmission according to Claim 4, **characterized in that** the concentration of the disperging additive in the lubricant and coolant in percent by weight is half to approximately the same as that of the carbon particles.

6. Operational transmission according to Claim 2, **characterized in that** the lubricant and coolant contains an antifoaming agent as a further additive.

7. Operational transmission according to Claim 2, **characterized in that** the lubricant and coolant contains a corrosion inhibitor as yet a further additive.

8. Operating fluid for a transmission comprising highly loaded gearwheels, whose housing forms a sump which contains a lubricant and coolant and into which the gearwheels dip, **characterized in that** said transmission contains, as a lubricant and coolant, a mixture of water and an aliphatic hydrocarbon comprising at least two hydroxyl groups or a compound which contains such a hydrocarbon and in which graphite particles with a grain size of less than 50 micrometers are suspended.

9. Operating fluid according to Claim 8, **characterized in that** the lubricant and coolant contains 25 to 75 percent by weight of the aliphatic hydrocarbon or of the compound which contains such hydrocarbons and 1 to 30 percent by weight of graphite in the form of flaky graphite particles with a grain size of less than 20 micrometers, residual water and further admixtures and/or additives.

10. Operating fluid according to Claim 9, **characterized in that** the lubricant and coolant contains 40 to 60 percent by weight of the aliphatic hydrocarbon or of the compound which contains such hydrocarbons and 2 to 25 percent by weight of graphite in the form of flaky graphite particles with a grain size of less than 12 micrometers, residual water and further admixtures and/or additives.

11. Operating fluid according to Claim 9, **characterized in that** the lubricant and coolant contains a disperging additive as a further additive.

12. Operating fluid according to Claim 11, **characterized in that** the concentration of the disperging additive in the lubricant and coolant in percent by weight is half to approximately the same as that of the carbon particles.

13. Operating fluid according to Claim 9, **characterized in that** the lubricant and coolant contains an antifoaming agent as a further additive.

14. Operating fluid according to Claim 9, **characterized in that** the lubricant and coolant contains a corrosion inhibitor as yet a further additive.

15. Method for commissioning a transmission, on the basis of the dry transmission, in the following steps:
a) mixing water, an aliphatic hydrocarbon comprising at least two hydroxyl groups or a compound which contains such a hydrocarbon and the graphite particles in a container outside the transmission;
b) filling the transmission with the lubricant and coolant according to Claim 1, at least to such an extent that at least one of the gearwheels dips into the lubricant and coolant;
c) unloaded spinning of the transmission until all the gearwheels are wetted with the lubricant and coolant, in which case a consistent film of lubrication is formed on said gearwheels.

16. Method for commissioning a transmission according to Claim 15, **characterized in that** as step a) the transmission is filled with the lubricant and coolant according to Claim 1 beyond the level of at least one of the axles, wherein said lubricant and coolant contains 5 to 20 percent by weight of graphite, and **in that** according to step b) the lubricant and coolant is let out at least partially and the transmission is filled with a lubricant and coolant according to Claim 1 to the operating level state, wherein said lubricant and coolant contains, if appropriate, a content of graphite particles which is reduced in accordance with the residual amount.

## Revendications

1. Engrenage prêt à l'emploi à roues d'engrenage hautement chargées, dont le boîtier forme un fond contenant un agent de lubrification et de refroidissement, dans lequel les roues d'engrenage sont immergées, **caractérisé en ce qu'**il contient en tant qu'agent de lubrification et de refroidissement un mélange d'eau et d'un hydrocarbure aliphatique contenant au moins deux groupes hydroxyle ou d'un composé contenant de tels hydrocarbures, dans lequel des particules de graphite d'une taille de particule inférieure à 50 micromètres sont mises en suspension.

2. Engrenage prêt à l'emploi selon la revendication 1, **caractérisé en ce que** l'agent de lubrification et de refroidissement contient 25 à 75 pourcent en poids de l'hydrocarbure aliphatique ou du composé contenant de tels hydrocarbures, et 1 à 30 pourcent en poids de graphite sous la forme de particules de graphite floconneuses d'une taille de particule inférieure à 20 micromètres, le reste étant de l'eau et des ajouts et/ou additifs supplémentaires.

3. Engrenage prêt à l'emploi selon la revendication 2, **caractérisé en ce que** l'agent de lubrification et de refroidissement contient 40 à 60 pourcent en poids de l'hydrocarbure aliphatique ou du composé contenant de tels hydrocarbures, et 2 à 20 pourcent en poids de graphite sous la forme de particules de graphite floconneuses d'une taille de particule inférieure à 12 micromètres, le reste étant de l'eau et des ajouts et/ou additifs supplémentaires.

4. Engrenage prêt à l'emploi selon la revendication 2, **caractérisé en ce que** l'agent de lubrification et de refroidissement contient un additif de dispersion en tant qu'additif supplémentaire.

5. Engrenage prêt à l'emploi selon la revendication 4, **caractérisé en ce que** la concentration de l'additif de dispersion dans l'agent de lubrification et de refroidissement en pourcent en poids est de la moitié de celle des particules de carbone à environ celle des particules de carbone.

6. Engrenage prêt à l'emploi selon la revendication 2, **caractérisé en ce que** l'agent de lubrification et de refroidissement contient un anti-mousse en tant qu'additif supplémentaire.

7. Engrenage prêt à l'emploi selon la revendication 2, **caractérisé en ce que** l'agent de lubrification et de refroidissement contient un inhibiteur de corrosion en tant qu'autre additif supplémentaire.

8. Liquide de fonctionnement pour un engrenage à roues d'engrenage hautement chargées, dont le boîtier forme un fond contenant un agent de lubrification et de refroidissement, dans lequel les roues d'engrenage sont immergées, **caractérisé en ce qu'**il contient en tant qu'agent de lubrification et de refroidissement un mélange d'eau et d'un hydrocarbure aliphatique contenant au moins deux groupes hydroxyle ou d'un composé contenant un tel hydrocarbure, dans lequel des particules de graphite d'une taille de particule inférieure à 50 micromètres sont mises en suspension.

9. Liquide de fonctionnement selon la revendication 8, **caractérisé en ce que** l'agent de lubrification et de refroidissement contient 25 à 75 pourcent en poids de l'hydrocarbure aliphatique ou du composé contenant de tels hydrocarbures, et 1 à 30 pourcent en poids de graphite sous la forme de particules de graphite floconneuses d'une taille de particule inférieure à 20 micromètres, le reste étant de l'eau et des ajouts et/ou additifs supplémentaires.

10. Liquide de fonctionnement selon la revendication 9, **caractérisé en ce que** l'agent de lubrification et de refroidissement contient 40 à 60 pourcent en poids de l'hydrocarbure aliphatique ou du composé contenant de tels hydrocarbures, et 2 à 25 pourcent en poids de graphite sous la forme de particules de graphite floconneuses d'une taille de particule inférieure à 12 micromètres, le reste étant de l'eau et des ajouts et/ou additifs supplémentaires.

11. Liquide de fonctionnement selon la revendication 9, **caractérisé en ce que** l'agent de lubrification et de refroidissement contient un additif de dispersion en tant qu'additif supplémentaire.

12. Liquide de fonctionnement selon la revendication 11, **caractérisé en ce que** la concentration de l'additif de dispersion dans l'agent de lubrification et de refroidissement en pourcent en poids est de la moitié de celle des particules de carbone à environ celle des particules de carbone.

13. Liquide de fonctionnement selon la revendication 9, **caractérisé en ce que** l'agent de lubrification et de refroidissement contient un anti-mousse en tant qu'additif supplémentaire.

14. Liquide de fonctionnement selon la revendication 9, **caractérisé en ce que** l'agent de lubrification et de refroidissement contient un inhibiteur de corrosion en tant qu'autre additif supplémentaire.

15. Procédé de première mise en service d'un engrenage, à partir de l'engrenage sec, selon les étapes suivantes :
a) mélange d'eau, d'un hydrocarbure aliphatique contenant au moins deux groupes hydroxyle ou d'un composé contenant un tel hydrocarbure et des particules de graphite dans un contenant à l'extérieur de l'engrenage,
b) remplissage de l'engrenage avec l'agent de lubrification et de refroidissement selon la revendication 1 au moins assez pour qu'au moins une des roues d'engrenage soit immergée dans l'agent de lubrification et de refroidissement,
c) rotation sans charge de l'engrenage, jusqu'à ce que toutes les roues d'engrenage soient mouillées avec l'agent de lubrification et de refroidissement, un film de lubrification permanent se formant sur celles-ci.

16. Procédé de première mise en service d'un engrenage selon la revendication 15, **caractérisé en ce qu'**en tant qu'étape a), l'engrenage est rempli jusqu'au niveau d'au moins un des axes avec l'agent de lubrification et de refroidissement selon la revendication 1, celui-ci contenant 5 à 20 pourcent en poids de graphite, et **en ce qu'**après l'étape b), l'agent de lubrification et de refroidissement est vidé au moins en partie et l'engrenage est rempli avec un agent de lubrification et de refroidissement selon la revendication 1 au niveau de l'engrenage, celui-ci contenant éventuellement une teneur réduite en particules de graphite correspondant à la quantité résiduelle.
